# EUROPEAN PATENT SPECIFICATION

(11) **EP 4 033 264 B1**
(45) Date of publication and mention of the grant of the patent: **24.04.2024**
(21) Application number: 19954754.8
(22) Date of filing: 06.12.2019
(51) Int. Cl.: G01R 31/385, G01R 1/073

(54) **PROBE MODULE SEPARATION-DISTANCE QUICK-ADJUSTMENT MECHANISM AND FORMING NEEDLE BED**
SCHNELLJUSTIERMECHANISMUS FÜR TRENNABSTAND ZWISCHEN SONDENMODULEN UND FORMUNGSNADELBETT
MÉCANISME DE RÉGLAGE RAPIDE DE DISTANCE DE SÉPARATION DE MODULE DE SONDE ET FONTURE DE FORMATION

(43) Date of publication of application: 27.07.2022
(73) Proprietor: Guangdong HYNN Technologies Co., Ltd., Dongguan, Guangdong 518000 (CN)
(72) Inventor: WEI, Shicheng, Dongguan, Guangdong 518000 (CN); WANG, Shoumo, Dongguan, Guangdong 518000 (CN); ZHOU, Junhui, Dongguan, Guangdong 518000 (CN); ZHAO, Shaohua, Dongguan, Guangdong 518000 (CN)
(74) Representative: Meyer, Thorsten
(86) International application number: PCT/CN2019/123664
(87) International publication number: WO 2021/109126

(56) References cited:
- CN-A- 108 963 344
- CN-A- 109 188 034
- CN-A- 109 216 750
- CN-A- 109 342 969
- CN-A- 109 709 492
- CN-U- 205 666 286
- CN-U- 205 882 076
- CN-U- 209 280 874
- CN-U- 209 280 874
- US-A1- 2019 067 759

## Description

### FIELD OF THE INVENTION

The present disclosure relates to the technical field of lithium battery testing, and in particular to a quick adjustment mechanism for spacing of probe modules and a formation chamber.

### BACKGROUND OF THE INVENTION

With the wide application of lithium-ion batteries with square aluminum casing in the new energy power industry, stricter and higher standards for the quality and consistency of such batteries has been proposed.

The existing lithium-ion battery testing equipment includes a lower frame structure and an upper frame structure located above the lower frame structure and supported by preset guide rods. The lower frame structure is provided with a coarse positioning platform for placing a tray fully loaded with lithium-ion battery packs, and the upper frame structure is installed with multiple sets of probe modules arranged horizontally. Each probe module includes a probe holder and multiple probe assemblies installed on the probe holder for testing the corresponding lithium-ion batteries, and the probe holder is fixed on the upper frame structure by screws. When testing different types of lithium-ion batteries with different dimensions, it is necessary to adjust the spacing among multiple sets of probe modules on the upper frame structure to improve the compatibility of the testing equipment.

However, because the probe holders are fixed to the upper frame structure by screws, it is necessary to manually loosen the screws firstly when adjusting the spacing among the sets of probe holders, and then move the probe holders back and forth or laterally to the desired position, and then re-lock each probe holder on the upper frame structure by means of screws. Such a method of manually adjusting the spacing between the sets of probe holders is time-consuming and laborious. CN 109 188 034 A, CN 109 342 969 A and CN 209 280 874 U each disclose test arrangements comprising probe modules and means for adjusting a distance between the probe modules.

### SUNIMARY OF THE INVENTION

Therefore, the technical problem to be solved by the present disclosure is to overcome the inconvenient adjustment problem resulting from that the probe holders are fixed to the upper frame structure by screws in the prior art, and a quick adjustment mechanism for spacing of probe modules and a formation chamber are provided accordingly.

To solve the above-mentioned technical problems, as a first aspect, the present disclosure provides a quick adjustment mechanism for spacing of probe modules including:
an upper frame, provided with upper guide rails on two opposite sides thereof and a mounting bracket, the mounting bracket being provided with a through slot arranged in a length direction of the upper guide rails;
multiple probe holders, arranged in the length direction of the upper guide rails, two ends of each probe holder being respectively slidably connected to a corresponding upper guide rail;
a pressing assembly, comprising a push rod movably installed on each probe holder along a vertical direction and slidably installed on the through slot along the length direction of the upper guide rail, a pressing plate connected to an outer circumference of the push rod and located between the mounting bracket and the probe holders, and an elastic member sleeved on the push rod and elastically supported between the pressing plate and the mounting bracket to provide an elastic force for actuating the pressing plate to press the probe holder, so as to lock the probe holder on the upper frame at a locking state; and
a positioning adjustment tool, located below the push rod and configured to lift up the push rod under a jacking mechanism to separate the pressing plate from the probe holder, so as to make the probe holder to be at an unlocked state and capable of sliding on the through slot.

In some embodiments, a top of the push rod is provided with a pressing block, the pressing block is configured to press against a top wall of the mounting bracket located at opposite sides of the through slot when the pressing plate is pressed against the probe holder; and the pressing block is configured to separate from the top wall of the mounting bracket when the pressing plate is lifted by the jacking mechanism.

In some embodiments, a side surface of the pressing block facing the through slot is provided with anti-slip dents.

In some embodiments, each of the probe holders is provided with an L-shaped plate comprising a vertical plate and a horizontal plate, the vertical plate is connected to the probe holder, the horizontal plate is provided with a hole to allow the push rod to insert, and the elastic member is elastically compressed between the horizontal plate and the pressing plate.

In some embodiments, a lower frame is provided below the upper frame, and the upper frame is supported above the lower frame by multiple guide rods; the jacking mechanism includes an intermediate frame sleeved on the guide rods and supported below the positioning adjustment tool and an driving cylinder mounted on the upper frame, and the driving cylinder has a driving end connected to the intermediate frame to actuate the intermediate frame to move along an axial direction of the guide rods.

In some embodiments, the positioning adjustment tool includes:
a mounting frame, supported by the intermediate frame;
a lower guide rails, provided at two opposite sides of the mounting frame and extended in an extending direction as the upper guide rails;
multiple adjusting plates configured to correspond to the probe holders, and two ends of each adjusting plate being respectively mounted on the lower guide rails; and
a second driving mechanism, installed on the mounting frame and configured to drive the adjusting plates to move along a length direction of the lower guide rails so as to drive the probe holders on the adjusting plates to slide.

In some embodiments, the second driving mechanism includes:
a driving motor mounted on the mounting frame;
a screw rod driven by the driving motor and having an axial direction same with the length direction of the lower guide rails; and
a nut connecting base that is in threaded connection to the screw rod and fixedly connected with the adjusting plate to drive the adjusting plate to move along an axis of screw rod with a rotation of screw rod.

In some embodiments, the intermediate frame is connected with a height limiting rod located between the intermediate frame and the upper frame.

In some embodiments, an outer wall of the push rod is fixedly connected with a handle.

As another aspect, the present disclosure further provides a formation chamber including the quick adjustment mechanism for spacing of probe modules as mentioned above.

The present disclosure has the following advantages.
1. In the quick adjustment mechanism for spacing of probe modules according to the present disclosure, the probe holders are slidably connected to the upper guide rail of the upper frame, and the pressing assembly is configured to apply a force on the corresponding probe holder through the pressing plate, so that the probe holder is locked on the upper frame at a locking state. When there is a need to adjust the mounting positions of certain probes on the upper frame, the positioning adjustment tool lifts up the push rod under the action of the jacking mechanism to separate the pressing plate from the probe holder, so as to make the probe holder to be at an unlocked state and capable of sliding on the through slot. After the positions of the probe holders are adjusted well, the action force of the jacking mechanism is withdrawn from the positioning adjustment tool, the push rod moves downward under the action of the elastic restoring force of the elastic member, so that the pressing plate is re-pressed on the probe holder to lock the probe holder. In such a way, the quick adjustment mechanism for spacing of probe modules according to the present disclosure can adjust the lateral positions of multiple probe holders at the same time, which improves the adjustment efficiency.
2. In the quick adjustment mechanism for spacing of probe modules according to the present disclosure, when the positioning adjustment tool 4 is lifted by the jacking mechanism, the positioning pin on the adjusting plate can insert into the positioning hole at the bottom of the probe holder to realize the positioning connection, and meanwhile the pushing block of the adjusting plate can lift up the push rod and further compresses the elastic member sleeved on the push rod, and the pressing plate on the push rod moves up with the push rod to release the locking of the probe holder; and then, the driving motor on the mounting frame drives the adjusting plate and the probe holder to move along the length direction of the lower guide rail through the transmission of the screw rod, which further shortens the adjustment time for the spacing between the probe holders, and improves the adjustment efficiency.
3. When there is a need to adjust the installation positions of the probe holders on the upper frame, the first drive device drives the positioning adjustment tool to move upward along the guide rods, so as to drive the positioning pin on the adjusting plate to insert into the positioning hole at the bottom of the probe holder, and meanwhile the pushing block of the adjusting plate lifts up the push rod and further compresses the elastic member, and the pressing plate on the push rod moves up with the push rod to release the locking of the probe holder; and then the second drive on the positioning adjustment tool is activated to drive the adjusting plate and the probe holder to move laterally by a screw rod. After a desired position for the probe holder is reached, the first drive device drives the positioning adjustment tool to move downward along the guide rods, the pushing block is separated from the push rod, and the positioning pin is separated from the positioning hole, thus the pushing rod moves downward under the action of the restoring force of the elastic member, causing the pressing plate to press the probe holder again, thereby locking the probe holder. In such a way, the installation positions of the probe holders can be adjusted automatically, which further improves the adjustment efficiency.

### BRIEF DESCRIPTION OF THE DRAWINGS

In order to more clearly illustrate the specific embodiments of the present disclosure, the accompanying drawings required in the description of the specific embodiments or the prior art will be briefly introduced below. Apparently, the drawings are only some embodiments of the present disclosure, and other drawings can also be obtained from these drawings without any creative effort for those of ordinary skill in the art. In such drawings:
FIG. 1 is a schematic diagram of the overall structure of a formation chamber according to an embodiment of the present disclosure;
FIG. 2 is a front view of a formation chamber according to an embodiment of the present disclosure;
FIG 3 is a right side view of the formation chamber according to an embodiment of the present disclosure;
FIG 4 is an enlarged view of portion A in FIG 2;
FIG 5 is an enlarged view of portion B in FIG 3;
FIG 6 is a schematic diagram of the overall structure of the positioning adjustment tool according to an embodiment of the present disclosure; and
FIG 7 is a top view of a positioning adjustment tool provided by an embodiment of the present disclosure.

### Reference signs:

1. Upper frame; 11. Upper guide rail; 12. Mounting frame; 2. Probe holder; 31. Push rod; 32. Pressing plate; 33. Elastic member; 34. Pressing block; 341. Anti-slip dents; 121. Through slot; 4. Positioning adjustment tooling; 41. Mounting frame; 42. Lower guide rail; 43. Adjusting plate; 431. Positioning pin; 432. Pushing block; 44. Driving motor; 45. Screw rod; 46. Nut connecting base; 51. Intermediate frame; 52. Driving cylinder; 6. L-shaped plate; 61. Vertical plate; 62. Horizontal plate; 7. Lower frame; 8. Guide rod; 9. Height limiting rod; 10. Handle.

### DETAILED DESCRIPTION OF ILLUSTRATED EMBODIMENTS

The technical solutions of the present disclosure will be clearly and completely described below with reference to the accompanying drawings. Obviously, the described embodiments are part of but not all of the embodiments of the present disclosure.

In the description of this application, it should be noted that the terms indicating orientations or positional relationships, such as "center", "upper", "lower", "left", "right", "vertical", "horizontal", "inner", "outer", etc. are based on the orientations or positional relationships shown in the accompanying drawings, which is only for the convenience of describing and simplifying the description, rather than for indicating or implying that the referred devices or elements must have a specific orientation or a construction and operation in the specific orientation, and therefore should not be construed as limitations on this application. Additionally, the terms "first", "second", and "third" are used for descriptive purposes only and should not be construed to indicate or imply relative importance.

In the description of this application, it should be noted that, unless otherwise expressly specified and limited, the terms "installed", "mounted" or "connected" should be understood in a broad sense, for example, the connection may be a fixed connection, a detachable connection, or an integral connection; the connection may be a mechanical connection or electrical connection; the mentioned objects may be directly connected, or indirectly connected through an intermediate medium, or may be internal communication between two elements. For those of ordinary skill in the art, the specific meanings of the above terms in this disclosure can be understood in specific situations.

In addition, the technical features involved in the different embodiments of the present disclosure described below can be combined with each other as long as there are no conflicts one another.

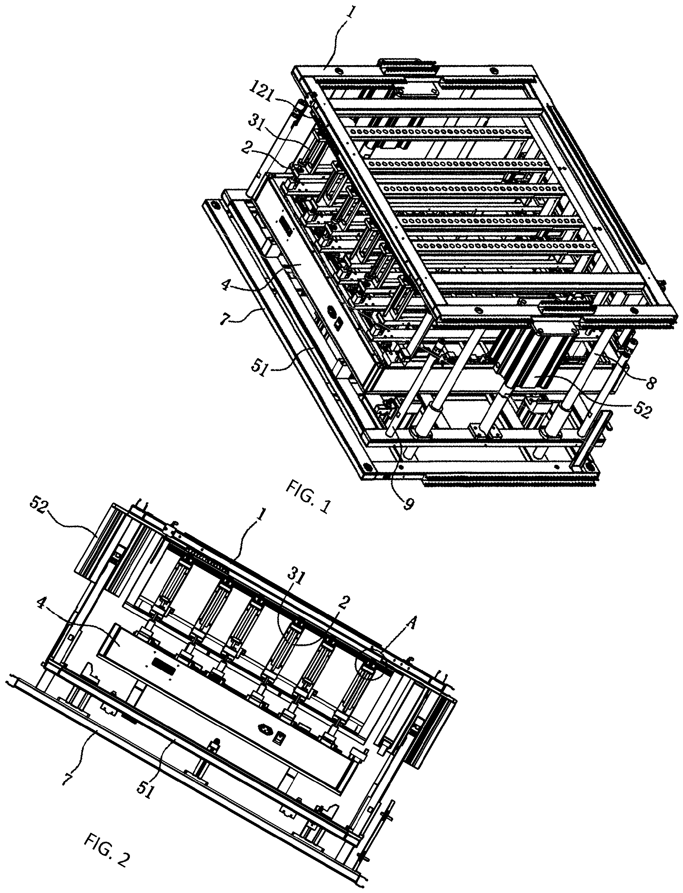

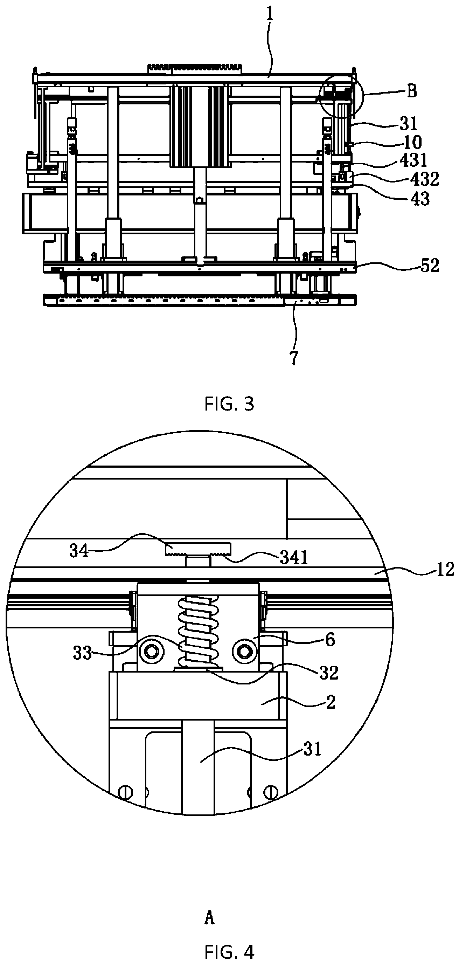

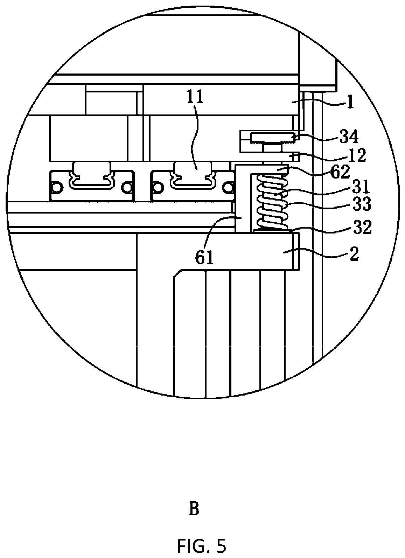

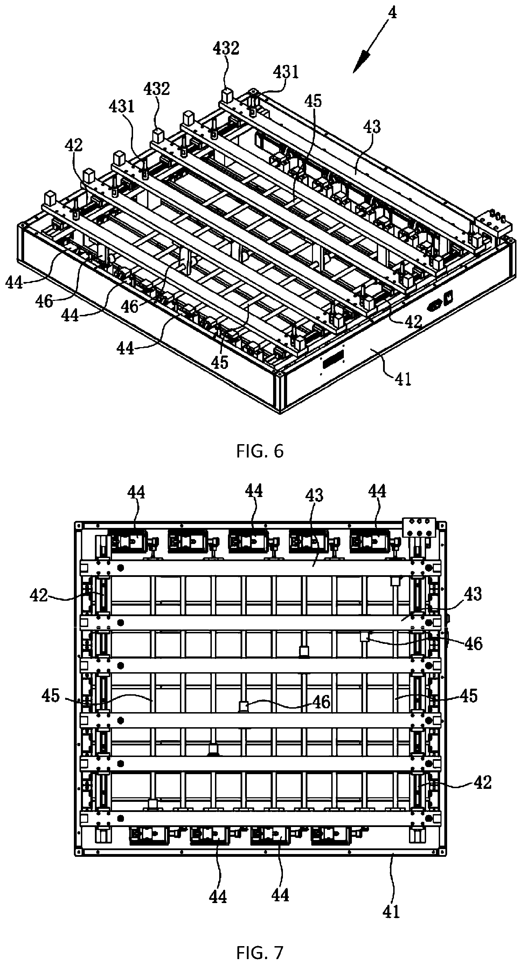

As shown in FIGS. 1-7, a quick adjustment mechanism for the spacing of probe modules includes an upper frame 1, multiple sets of probe holders 2 installed under the upper frame 1, a pressing assembly for pressing the probe holders on the upper frame 1, and a positioning adjustment tool 4 for adjusting the installation position of the probe holders 2 on the upper frame 1.

In this embodiment, upper guide rails 11 and a mounting bracket 12 are respectively provided on opposite sides of the upper frame 1. The mounting bracket 12 is provided with a through groove 121 arranged along the length direction of the upper guide rails 11, and two ends of each probe holder 2 are respectively slidably connected to the corresponding upper guide rail 11 through a respective slider structure. Specifically, two sets of upper guide rails 11 are located above and below the probe holders 2 respectively, and six sets of the probe holders 2 are configured. It should be understood that the number of the probe holders 2 can be adaptively selected as required.

In this embodiment, the pressing assembly includes: a push rod 31 movably installed on the probe holder 2 along a vertical direction and slidably mounted on the through slot 121 along the length direction of the upper guide rail 11; a pressing plate 32 connected to an outer circumference of the push rod 31 and located between the mounting bracket 12 and the probe holder 2; and an elastic member 33 sleeved on the push rod 31 and elastically supported between the pressing plate 32 and the mounting bracket 12 to provide an elastic force for actuating the pressing plate 32 to press the probe holder 2, so as to lock the probe holder 2 on the upper frame 1 at a locking state. The positioning adjustment tool 4 is located below the push rod 31 and configured to lift up the push rod 31 under a jacking mechanism to separate the pressing plate 32 from the probe holder 2, so as to make the probe holder 2 to be at an unlocked state and capable of sliding on the through slot 121.

In this quick adjustment mechanism for spacing of probe modules, multiple sets of probe holders 2 are slidably connected to the upper guide rails 11 of the upper frame 1, and the pressing assembly is configured to apply a force on the corresponding probe holder 2 through the pressing plate 32, so that the probe holder 2 can be locked on the upper frame 1 in a locked state. When it is necessary to adjust the installation positions of several probe holders 2 on the upper frame 1, the push rod 31 is lifted up by the positioning adjustment tool 4 under the action of the jacking mechanism, thereby separating the pressing plate 32 from the probe holders 2. At this time, the probe holder 2 is in an unlocked state that can slide freely in the through slot 121, that is to say, the positions of the probe holders 2 can be adjusted in the through slot 121. After the positions of several groups of probe holders 2 are adjusted well, the action force of the jacking mechanism is withdrawn from the positioning adjustment tool 4, the push rod 31 moves downward under the action of the elastic restoring force of the elastic member 33, so that the pressing plate 32 is re-pressed on the probe holder 2 to lock the probe holder 2. In such a way, the quick adjustment mechanism for spacing of probe modules according to the present disclosure can adjust the lateral positions of multiple probe holders 2 at the same time, which has high adjustment efficiency and low labor intensity.

In this embodiment, the upper end of the push rod 31 is inserted in the through groove 121 of the mounting plate, with the top end of the push rod 31 is connected with a pressing block 34. Specifically, the pressing block 34 is configured to press against a top wall of the mounting bracket 12 located at opposite sides of the through slot 121 when the pressing plate 32 is pressed against the probe holder 2, and the pressing block 34 is configured to separate from the top wall of the mounting bracket 12 when the pressing plate 32 is lifted by the jacking mechanism. Due to the arrangement of the pressing block 34 on the push rod 31, the pressing block 34 may apply a pressing effect on the mounting bracket 12 when the probe holder 2 is locked by the pressing plate 32 in the locked state, thereby improving the stability of the probe holder 2 under the locked state.

Further, the side surface of the pressing block 34 facing the mounting bracket 12 is provided with anti-slip dents 341, such that the contact area and frictional force between the pressing block 34 and the mounting bracket 12 are increased, thereby preventing the pressing block 34 from sliding on the mounting bracket 12 to further improve the stability of the push rod 31 under the pressed state.

In this embodiment, the probe holder 2 is provided with an L-shaped plate 6 including a vertical plate 61 and a horizontal plate 62, the vertical plate 61 is connected to the probe holders 2, the horizontal plate 62 is provided with a hole to allow the push rod 31 to insert, and the elastic member 33 is elastically compressed between the horizontal plate 62 and the pressing plate 32. Specifically, the elastic member 33 is a compression spring sleeved between the horizontal plate 62 and the vertical plate 61. Therefore, the arrangement of the L-shaped plate 6 on the probe holder 2 can provide an installation space with a suitable height for the elastic member 33.

In this embodiment, a lower frame 7 is provided below the upper frame 1, and the upper frame 1 is supported above the lower frame 7 through four guide rods 8. The jacking mechanism includes an intermediate frame 51 sleeved on the guide rods 8 and supported between the upper frame 1 and the lower frame 7, and an driving cylinder 52 mounted on the upper frame 1. Specifically, the driving cylinder 52 has a driving end connected to the intermediate frame 51 for actuating the intermediate frame 51 to move along an axial direction of the guide rods 8. Specifically, the intermediate frame 51 is supported below the positioning adjustment tool 4. During the unlocking process of the probe holder 2, the driving cylinder 52 drives the intermediate frame 51 to move upward along the axis of the guide rods 8, thereby driving the positioning adjustment tool 4 supported on the intermediate frame 51 to move upward. At this time, the push rod 31 is lifted up under the action of the positioning adjustment tool 4, thereby separating the pressing plate 32 from the probe holder 2, causing the probe holder 2 to be in an unlocked state that can slide freely in the through groove 121. During the locking process of the probe holder 2, the driving cylinder 52 drives the intermediate frame 51 to move downward along the axis of the guide rods 8, and then drives the positioning adjustment tool 4 supported on the intermediate frame 51 to move downward. At this time, lifting force of the positioning adjustment tool 4 is withdrawn from the push rod 31, thus the push rod 31 moves downward under the action of the elastic restoring force of the elastic member 33, until pressing against the probe holder 2, such that the probe holder 2 is locked on the upper frame 1 again.

Further, in order to prevent an excessive upper movement of the intermediate frame 51 and the positioning adjustment tool 4, which may result in damage to the driving cylinder 52 or other components, a height limiting rod 9 facing the upper frame 1 is fixedly arranged at each corner of the intermediate frame 51.

In this embodiment, the positioning adjustment tool 4 includes a mounting frame 41 supported by the intermediate frame 51; lower guide rails 42 provided at two opposite sides of the mounting frame 41 and extended in an extending direction as the upper guide rail 11; multiple adjusting plates 43 configured to correspond to the probe holders 2, and two ends of each adjusting plate 43 being respectively mounted on the lower guide rail 42; and a second driving mechanism installed on the mounting frame 41 and configured to driving the adjusting plates 43 to move along a length direction of the lower guide rail 42 so as to drive the probe holders 2 on the adjusting plates 43 to slide. A positioning pin 431 and a pushing block 432 are configured above the adjusting plate 43, the positioning pin 431 is connected to the probe holders 2, and the pushing block 432 is arranged in a position corresponding to the push rod 31. The second driving mechanism includes a driving motor 44 mounted on the mounting frame 41; a screw rod 45 driven by the driving motor 44 and having an axial direction same with the length direction of the lower guide rail 42; and a nut connecting base 46 that is in threaded connection to the screw rod 45 and fixedly connected with the adjusting plate 43 to drive the adjusting plate 43 to move along the axis of screw rod 45 with the rotation of screw rod 45.

During the process of lifting up the positioning adjustment tool 4 by the jacking mechanism, the positioning pin 431 on the adjusting plate 43 inserts into the positioning hole at the bottom of the probe holder 2 to realize the positioning connection, and meanwhile the pushing block 432 of the adjusting plate 43 lifts up the push rod 31 and further compresses the elastic member 33 sleeved on the push rod 31, and the pressing plate 32 on the push rod 31 moves up with the push rod 31 to release the locking of the probe holder 2; and then the driving motor 44 on the mounting frame 41 drives the adjustment plate 43 and the probe holder 2 to move along the length direction of the lower guide rail 42 through the transmission of the screw rod 45. In such a way, the installation position of the probe holders 2 can be automatically adjusted, the time for the spacing adjustment is shortened, the adjustment accuracy is increased, and the labor intensity is effectively reduced.

In some implementations of this embodiment, a handle 10 is connected on the outer wall of the push rod 31, and the outer diameter of the handle 10 is larger than that of the push rod 31. Based on such an arrangement, it is convenient for operators to hold the handle 10 to lift up the push rod 31, thereby unlocking the probe holder 2, so that the position of the probe holder 2 in the through groove 121 can be changed by manual adjustment. Such a manual adjustment for the probe holder 2 has simple structure and convenient operation, and no additional driving motor 44 is used.

On the other hand, the embodiment of the present disclosure also provides a formation chamber, which includes a lower frame 7, an upper frame 1 supported above the lower frame 7 through a plurality of guide rods 8, and the mentioned-above spacing quick adjustment mechanism for probe modules mounted on the upper frame 1.

To sum up, in the quick adjustment mechanism for the spacing of the probe modules and the formation chamber provided in the embodiment of the present disclosure, probe holders 2 are pressed on the upper frame 1 by multiple pressing assemblies, where there is a need to adjust the lateral spacing of the probe holders 2, the driving cylinder 52 drives the mounting frame 41 to move upward, causing the pushing block 432 of the adjusting plate 43 to lift up the push rod 31 to separate the pressing plate 32 from the probe holder 2 and compress the elastic member 33, thus the probe holder 2 is in an unlocked state that can slide freely in the through slot 121. And then, the driving motor 44 on the mounting frame 41 drives the adjusting plate 43 to move along the length direction of the lower guide rail 42 through the transmission of the screw rod 45, thereby driving the probe holder 2 on the adjusting plate 43 to move along the length direction of the through slot 121. When a desired position for the probe holder 2 is reached, the driving cylinder 52 drives the intermediate frame 51 to move downward along the axis of the guide rods 8, and then drives the mounting frame 41 and the adjusting plate 43 to move downward. At this time, the supporting force of the pushing block 432 to the push rod 31 is withdrawn, thus the push rod 31 moves downward under the action of the elastic restoring force of the elastic member 33, causing the pressing plate 32 to re-press on the probe holder 2 so as to lock the probe holder 2. In such a way, the lateral installation positions of the probe holders 2 can be automatically adjusted, the time for the spacing adjustment is shortened, the adjustment accuracy is increased, and the labor intensity is effectively reduced.

## Claims

1. A quick adjustment mechanism for spacing of probe modules, comprising:
an upper frame (1), provided with upper guide rails (11) on two opposite sides thereof and a mounting bracket (12);
multiple probe holders (2), arranged in the length direction of the upper guide rails (11), two ends of each probe holder (2) being respectively slidably connected to a corresponding upper guide rail (11);
**characterized in that**:
the mounting bracket (12) is provided with a through slot (121) arranged in a length direction of the upper guide rails (11); wherein the quick adjustment mechanism further comprises
a pressing assembly, comprising a push rod (31) movably installed on each probe holder (2) along a vertical direction and slidably installed on the through slot (121) along the length direction of the upper guide rail (11), a pressing plate (32) connected to an outer circumference of the push rod (31) and located between the mounting bracket (12) and the probe holders (2), and an elastic member (33) sleeved on the push rod (31) and elastically supported between the pressing plate (32) and the mounting bracket (12) to provide an elastic force for actuating the pressing plate (32) to press the probe holder (2), so as to lock the probe holder (2) on the upper frame (1) at a locking state; and
a positioning adjustment tool (4), located below the push rod (31) and configured to lift up the push rod (31) under a jacking mechanism to separate the pressing plate (32) from the probe holder (2), so as to make the probe holder (2) to be at an unlocked state and capable of sliding on the through slot (121).

2. The quick adjustment mechanism for spacing of probe modules according to claim 1, wherein a top of the push rod (31) is provided with a pressing block (34), the pressing block (34) is configured to press against a top wall of the mounting bracket (12) located at opposite sides of the through slot (121) when the pressing plate (32) is pressed against the probe holder (2); and the pressing block (34) is configured to separate from the top wall of the mounting bracket (12) when the pressing plate (32) is lifted by the jacking mechanism.

3. The quick adjustment mechanism for spacing of probe modules according to claim 2, wherein a side surface of the pressing block (34) facing the through slot (121) is provided with anti-slip dents (341).

4. The quick adjustment mechanism for spacing of probe modules according to claim 1, wherein each of the probe holders (2) is provided with an L-shaped plate (6) comprising a vertical plate (61) and a horizontal plate (62), the vertical plate (61) is connected to the probe holder (2), the horizontal plate (62) is provided with a hole to allow the push rod (31) to insert, and the elastic member (33) is elastically compressed between the horizontal plate (62) and the pressing plate (32).

5. The quick adjustment mechanism for spacing of probe modules according to claim 1, wherein a lower frame (7) is provided below the upper frame (1), and the upper frame (1) is supported above the lower frame (7) by multiple guide rods (8); the jacking mechanism comprises an intermediate frame (51) sleeved on the guide rods (8) and supported below the positioning adjustment tool (4) and an driving cylinder (52) mounted on the upper frame (1), and the driving cylinder (52) has a driving end connected to the intermediate frame (51) to actuate the intermediate frame (51) to move along an axial direction of the guide rods (8).

6. The quick adjustment mechanism for spacing of probe modules according to claim 5, wherein the positioning adjustment tool (4) comprises:
a mounting frame (41) supported by the intermediate frame (51);
lower guide rails (42) provided at two opposite sides of the mounting frame (41) and extended in an extending direction as the upper guide rails (11);
multiple adjusting plates (43) configured to correspond to the probe holders (2), and two ends of each adjusting plate (43) being respectively mounted on the lower guide rails (42); and
a second driving mechanism installed on the mounting frame (41) and configured to drive the adjusting plates (43) to move along a length direction of the lower guide rails (42) so as to drive the probe holders (2) on the adjusting plates (43) to slide.

7. The quick adjustment mechanism for spacing of probe modules according to claim 6, wherein the second driving mechanism comprises:
a driving motor (44) mounted on the mounting frame (41);
a screw rod (45) driven by the driving motor (44) and having an axial direction same with the length direction of the lower guide rails (42); and
a nut connecting base (46) that is in threaded connection to the screw rod (45) and fixedly connected with the adjusting plate (43) to drive the adjusting plate (43) to move along an axis of screw rod (45) with a rotation of screw rod (45).

8. The quick adjustment mechanism for spacing of probe modules according to claim 6, wherein the intermediate frame (51) is connected with a height limiting rod (9) located between the intermediate frame (51) and the upper frame (1).

9. The quick adjustment mechanism for spacing of probe modules according to claim 1, wherein an outer wall of the push rod (31) is fixedly connected with a handle (10).

10. A formation chamber, comprising the quick adjustment mechanism for spacing of probe modules according to any one of claims 1-9.

## Patentansprüche

1. Schnelljustiermechanismus für eine Beabstandung von Sondenmodulen, umfassend:
einen oberen Rahmen (1), der mit oberen Führungsschienen (11) an zwei gegenüberliegenden Seiten davon und einer Montagehalterung (12) versehen ist;
mehrere Sondenaufnahmen (2), die in der Längsrichtung der oberen Führungsschienen (11) angeordnet sind, wobei jeweils zwei Enden jeder Sondenaufnahme (2) gleitend mit einer entsprechenden oberen Führungsschiene (11) verbunden sind;
**dadurch gekennzeichnet, dass**:
die Montagehalterung (12) mit einem Durchgangsschlitz (121) versehen ist, der in einer Längsrichtung der oberen Führungsschienen (11) angeordnet ist; wobei der Schnelljustiermechanismus ferner umfasst:
eine Pressanordnung, umfassend eine Schubstange (31), die beweglich an jeder Sondenaufnahme (2) entlang einer vertikalen Richtung installiert ist und gleitend am Durchgangsschlitz (121) entlang der Längsrichtung der oberen Führungsschiene (11) installiert ist, eine Pressplatte (32), die mit einem Außenumfang der Schubstange (31) verbunden ist und zwischen der Montagehalterung (12) und den Sondenaufnahmen (2) angeordnet ist, und ein elastisches Element (33), das die Schubstange (31) ummantelt und elastisch zwischen der Pressplatte (32) und der Montagehalterung (12) getragen wird, um eine elastische Kraft zum Betätigen der Pressplatte (32) bereitzustellen, um so auf die Sondenaufnahme (2) zu drücken, dass die Sondenaufnahme (2) am oberen Rahmen (1) in einem Verriegelungszustand verriegelt ist; und
ein Positionsjustierwerkzeug (4), das sich unter der Schubstange (31) befindet und ausgelegt ist, die Schubstange (31) unter einem Hubmechanismus anzuheben, um die Pressplatte (32) von der Sondenaufnahme (2) zu trennen, sodass die Sondenaufnahme (2) in einen entriegelten Zustand gebracht wird und auf dem Durchgangsschlitz (121) gleiten kann.

2. Schnelljustiermechanismus für eine Beabstandung von Sondenmodulen nach Anspruch 1, wobei eine Oberseite der Schubstange (31) mit einem Pressblock (34) versehen ist, der Pressblock (34) ausgelegt ist, an eine obere Wand der Montagehalterung (12), die an gegenüberliegenden Seiten des Durchgangsschlitzes (121) angeordnet ist, zu drücken, wenn die Pressplatte (32) an die Sondenaufnahme (2) gedrückt wird; und der Pressblock (34) ausgelegt ist, sich von der oberen Wand der Montagehalterung (12) zu trennen, wenn die Pressplatte (32) vom Hubmechanismus angehoben wird.

3. Schnelljustiermechanismus für eine Beabstandung von Sondenmodulen nach Anspruch 2, wobei eine zum Durchgangsschlitz (121) zeigende Seitenfläche des Pressblocks (34) mit Antirutsch-Kerben (341) versehen ist.

4. Schnelljustiermechanismus für eine Beabstandung von Sondenmodulen nach Anspruch 1, wobei jede der Sondenaufnahmen (2) mit einer L-förmigen Platte (6) versehen ist, die eine vertikale Platte (61) und eine horizontale Platte (62) umfasst, wobei die vertikale Platte (61) mit der Sondenaufnahme (2) verbunden ist, die horizontale Platte (62) mit einem Loch versehen ist, um ein Einsetzen der Schubstange (31) zu ermöglichen, und das elastische Element (33) elastisch zwischen der horizontalen Platte (62) und der Pressplatte (32) komprimiert wird.

5. Schnelljustiermechanismus für eine Beabstandung von Sondenmodulen nach Anspruch 1, wobei ein unterer Rahmen (7) unter dem oberen Rahmen (1) vorgesehen ist und der obere Rahmen (1) über dem unteren Rahmen (7) von mehreren Führungsstangen (8) getragen wird; wobei der Hubmechanismus einen Zwischenrahmen (51) umfasst, der die Führungsstangen (8) ummantelt und unter dem Positionsjustierwerkzeug (4) getragen wird, und ein Antriebszylinder (52) am oberen Rahmen (1) montiert ist und der Antriebszylinder (52) ein Antriebsende aufweist, das mit dem Zwischenrahmen (51) verbunden ist, um den Zwischenrahmen (51) zu betätigen, sodass er sich entlang einer axialen Richtung der Führungsstangen (8) bewegt.

6. Schnelljustiermechanismus für eine Beabstandung von Sondenmodulen nach Anspruch 5, wobei das Positionsjustierwerkzeug (4) umfasst:
einen Montagerahmen (41), der vom Zwischenrahmen (51) getragen wird;
untere Führungsschienen (42), die an zwei gegenüberliegenden Seiten des Montagerahmens (41) vorgesehen sind und in einer Verlaufsrichtung der oberen Führungsschienen (11) verlaufen;
mehrere Justierplatten (43), die ausgelegt sind, den Sondenaufnahmen (2) zu entsprechen, und wobei zwei Enden jeder Justierplatte (43) jeweils an den unteren Führungsschienen (42) montiert ist; und
einen zweiten Antriebsmechanismus, der am Montagerahmen (41) installiert ist und ausgelegt ist, die Justierplatten (43) anzutreiben, sodass sich sich entlang einer Längsrichtung der unteren Führungsschienen (42) bewegen, um die Sondenaufnahmen (2) anzutreiben, sodass sie auf den Justierplatten (43) verschoben werden.

7. Schnelljustiermechanismus für eine Beabstandung von Sondenmodulen nach Anspruch 6, wobei der zweite Antriebsmechanismus umfasst:
einen Antriebsmotor (44), der am Montagerahmen (41) montiert ist;
eine Gewindestange (45), die vom Antriebsmotor (44) angetrieben wird und eine axiale Richtung aufweist, die mit der Längsrichtung der unteren Führungsschienen (42) übereinstimmt; und
eine Mutternverbindungsbasis (46), die in Schraubverbindung mit der Gewindestange (45) steht und fest mit der Justierplatte (43) verbunden ist, um die Justierplatte (43) anzutreiben, sodass sie sich mit einer Drehung der Gewindestange (45) entlang einer Achse der Gewindestange (45) bewegt.

8. Schnelljustiermechanismus für eine Beabstandung von Sondenmodulen nach Anspruch 6, wobei der Zwischenrahmen (51) mit einer Höhenbegrenzungsstange (9) verbunden ist, die sich zwischen dem Zwischenrahmen (51) und dem oberen Rahmen (1) befindet.

9. Schnelljustiermechanismus für eine Beabstandung von Sondenmodulen nach Anspruch 1, wobei eine Außenwand der Schubstange (31) fest mit einem Griff (10) verbunden ist.

10. Formungskammer, die den Schnelljustiermechanismus für eine Beabstandung von Sondenmodulen nach einem der Ansprüche 1-9 umfasst.

## Revendications

1. Mécanisme d'ajustement rapide pour l'espacement de modules de sonde, comprenant :
un cadre supérieur (1), pourvu de rails de guidage supérieurs (11) sur deux côtés opposés de celui-ci et d'un support de montage (12) ;
de multiples supports de sonde (2), agencés dans la direction longitudinale des rails de guidage supérieurs (11), deux extrémités de chaque support de sonde (2) étant respectivement connectées à coulissement à un rail de guidage supérieur correspondant (11) ;
**caractérisé en ce que** :
le support de montage (12) est pourvu d'une fente traversante (121) agencée dans une direction longitudinale des rails de guidage supérieurs (11) ; dans lequel le mécanisme d'ajustement rapide comprend en outre
un ensemble de pression, comprenant une tige de poussée (31) installée de manière mobile sur chaque support de sonde (2) le long d'une direction verticale et installée à coulissement sur la fente traversante (121) le long de la direction longitudinale du rail de guidage supérieur (11), une plaque de pression (32) connectée à une circonférence externe de la tige de poussée (31) et située entre le support de montage (12) et les supports de sonde (2), et un élément élastique (33) manchonné sur la tige de poussée (31) et supporté élastiquement entre la plaque de pression (32) et le support de montage (12) pour fournir une force élastique pour actionner la plaque de pression (32) pour presser le support de sonde (2) de manière à verrouiller le support de sonde (2) sur le cadre supérieur (1) à un état de verrouillage ; et
un outil d'ajustement de positionnement (4), positionné en dessous de la tige de poussée (31) et configuré pour soulever la tige de poussée (31) sous un mécanisme de mise sur vérins pour séparer la plaque de pression (32) du support de sonde (2) de manière à amener le support de sonde (2) à être à un état déverrouillé et capable de coulisser sur la fente traversante (121).

2. Mécanisme d'ajustement rapide pour l'espacement de modules de sonde selon la revendication 1, dans lequel un haut de la tige de poussée (31) est pourvu d'un bloc de pression (34), le bloc de pression (34) est configuré pour appuyer sur une paroi supérieure du support de montage (12) située sur des côtés opposés de la fente traversante (121) lorsque la plaque de pression (32) est appuyée sur le support de sonde (2) ; et le bloc de pression (34) est configuré pour se séparer de la paroi supérieure du support de montage (12) lorsque la plaque de pression (32) est soulevée par le mécanisme de mise sur vérins.

3. Mécanisme d'ajustement rapide pour l'espacement de modules de sonde selon la revendication 2, dans lequel une surface latérale du bloc de pression (34) tournée vers la fente traversante (121) est pourvue d'indentations antidérapantes (341).

4. Mécanisme d'ajustement rapide pour l'espacement de modules de sonde selon la revendication 1, dans lequel chacun des supports de sonde (2) est pourvu d'une plaque en forme de L (6) comprenant une plaque verticale (61) et une plaque horizontale (62), la plaque verticale (61) est connectée au support de sonde (2), la plaque horizontale (62) est pourvue d'un orifice pour permettre à la tige de poussée (31) de s'insérer, et l'élément élastique (33) est comprimé élastiquement entre la plaque horizontale (62) et la plaque de pression (32).

5. Mécanisme d'ajustement rapide pour l'espacement de modules de sonde selon la revendication 1, dans lequel un cadre inférieur (7) est prévu en dessous du cadre supérieur (1), et le cadre supérieur (1) est supporté au-dessus du cadre inférieur (7) par de multiples tiges de guidage (8) ; le mécanisme de mise sous vérins comprend un cadre intermédiaire (51) manchonné sur les tiges de guidage (8) et supporté en dessous de l'outil d'ajustement de positionnement (4) et d'un cylindre d'entraînement (52) monté sur le cadre supérieur (1), et le cylindre d'entraînement (52) a une extrémité d'entraînement connectée au cadre intermédiaire (51) pour actionner le cadre intermédiaire (51) à se déplacer le long d'une direction axiale des tiges de guidage (8).

6. Mécanisme d'ajustement rapide pour l'espacement de modules de sonde selon la revendication 5, dans lequel l'outil d'ajustement de positionnement (4) comprend :
un cadre de montage (41) supporté par le cadre intermédiaire (51) ;
des rails de guidage inférieurs (42) prévus sur deux côtés opposés du cadre de montage (41) et étendus dans une direction d'extension comme les rails de guidage supérieurs (11) ;
de multiples plaques d'ajustement (43) configurées pour correspondre aux supports de sonde (2), et deux extrémités de chaque plaque d'ajustement (43) étant respectivement montées sur les rails de guidage inférieurs (42) ; et
un second mécanisme d'entraînement installé sur le cadre de montage (41) et configuré pour entraîner les plaques d'ajustement (43) à se déplacer le long d'une direction longitudinale des rails de guidage inférieurs (42) de manière à entraîner les supports de sonde (2) sur les plaques d'ajustement (43) à coulisser.

7. Mécanisme d'ajustement rapide pour l'espacement de modules de sonde selon la revendication 6, dans lequel le second mécanisme d'entraînement comprend :
un moteur d'entraînement (44) monté sur le cadre de montage (41) ;
une tige vissée (45) entraînée par le moteur d'entraînement (44) et ayant une direction axiale identique à la direction longitudinale des rails de guidage inférieurs (42) ; et
une base de connexion à écrou (46) qui est en connexion filetée à la tige vissée (45) et connectée de manière fixe à la plaque d'ajustement (43) pour entraîner la plaque d'ajustement (43) à se déplacer le long d'un axe de la tige vissée (45) avec une rotation de la tige vissée (45).

8. Mécanisme d'ajustement rapide pour l'espacement de modules de sonde selon la revendication 6, dans lequel le cadre intermédiaire (51) est connecté à une tige de limitation de hauteur (9) située entre le cadre intermédiaire (51) et le cadre supérieur (1).

9. Mécanisme d'ajustement rapide pour l'espacement de modules de sonde selon la revendication 1, dans lequel une paroi externe de la tige de poussée (31) est connectée de manière fixe à une poignée (10).

10. Chambre de formation, comprenant le mécanisme d'ajustement rapide pour l'espacement de modules de sonde selon l'une quelconque des revendications 1 à 9.
